# FASCICULE DE BREVET EUROPEEN

(11) **EP 3 439 128 B1**
(45) Date de publication et mention de la délivrance du brevet: **05.01.2022**
(21) Numéro de dépôt: 18172800.7
(22) Date de dépôt: 17.05.2018
(51) Int. Cl.: H02H 1/00

(54) **PROCÉDÉ ET DISPOSITIF DE PROTECTION CONTRE LES DÉFAUTS D'ARC INTERNE DANS UN SYSTÈME DE DISTRIBUTION ÉLECTRIQUE, ET ARMOIRE ÉLECTRIQUE COMPORTANT UN TEL DISPOSITIF**
SCHUTZVERFAHREN UND -VORRICHTUNG GEGEN INTERNE LICHTBOGENFEHLER IN EINEM ELEKTRISCHEN VERTEILUNGSSYSTEM, UND ELEKTRISCHER SCHALTSCHRANK, DER EINE SOLCHE VORRICHTUNG UMFASST
METHOD AND DEVICE FOR PROTECTION AGAINST INTERNAL ARCING FAULTS IN AN ELECTRICAL DISTRIBUTION SYSTEM, AND ELECTRICAL CABINET COMPRISING SUCH A DEVICE

(30) Priorité: 03.08.2017 FR 1757447
(43) Date de publication de la demande: 06.02.2019
(73) Titulaire: Schneider Electric Industries SAS, 92500 Rueil-Malmaison (FR)
(72) Inventeur: RIVAL, Marc, 38050 GRENOBLE (FR)
(74) Mandataire: Colette, Marie-Françoise

(56) Documents cités:
- EP-A1- 0 853 360
- EP-A2- 1 077 518
- CN-A- 103 364 697
- CN-A- 105 356 426
- DD-A1- 254 278
- DE-A1-102015 217 633
- DE-C2- 3 890 265
- DE-U1- 29 502 452
- US-A1- 2008 094 612
- US-A1- 2009 161 272

## Description

### DOMAINE TECHNIQUE

La présente invention concerne la protection contre les défauts d'arc interne en particulier dans les systèmes de distribution électrique tels que les armoires électriques. Plus précisément, elle se rapporte à des dispositifs de protection permettant un déclenchement sélectif entre les défauts d'arcs internes et les défauts de court circuits dits « boulonnés » éliminés par les disjoncteurs basse tension à coupure dans l'air situés en aval du disjoncteur principal.

### ETAT DE LA TECHNIQUE ANTERIEURE

Les systèmes de distribution électrique basse tension comportent des organes de commande et de protection tels que des disjoncteurs ou des contacteurs basse tension connectés entre eux par des conducteurs (barres ou câbles). L'interruption de la circulation du courant dans les conducteurs s'effectue par ouverture d'un ou plusieurs organes de commande générant un arc électrique. Lors de l'interruption de courants égaux ou inférieurs au courant nominal, les arcs causés par l'interruption sont contenus par les disjoncteurs ou les contacteurs. Ils émettent peu de lumière. Lors de 'courants de court-circuit plus importants, une forte lumière est émise par ces dispositifs à l'extérieur de ceux-ci.

Parfois, des arcs électriques dits de défaut d'arc interne, non souhaités, peuvent se produire à l'intérieur des armoires électriques, par exemple entre les conducteurs, ou entre un conducteur et un composant métallique connecté à la terre. Ces arcs peuvent produire des gaz à haute énergie, lesquels gaz constituent une menace pour la structure et le personnel situé à arcs se produisent généralement lorsqu'une erreur est réalisée par une personne travaillant à proximité des parties sous tension.

Récemment, des méthodes ont été mises au point pour minimiser la gravité de l'explosion d'un défaut d'arc interne. Une de ces méthodes comprend les mesures simultanées de l'intensité de la lumière émise par l'arc de défaut et de l'intensité du courant passant dans le jeu de barres en amont du défaut. En associant les deux mesures, cette méthode permet d'éviter des déclenchements intempestifs des capteurs optiques dus à la lumière émise par d'autres sources de lumière comme des lampes d'inspection de l'installation, mais ne permet pas d'assurer la distinction entre les défauts.

En effet, en associant les mesures simultanées de lumière et de courant, l'on diminue le risque de déclenchement intempestif qui serait dû à un faisceau lumineux puissant parasite qui éblouirait les capteurs optiques. Avec la mesure de courant simultané qui nécessiterait un courant de surcharge supérieure à quatre fois le courant nominal par exemple pour activer le capteur, le risque de déclenchement intempestif est très diminué.

Cependant, lorsqu'un disjoncteur basse tension situé en aval du dispositif optique élimine un défaut de court-circuit dit « boulonné », il émet une lumière simultanément au passage du courant limité dans le circuit. Il y a alors un risque de déclenchement intempestif. Or, dans ce cas précis, l'on ne souhaite pas l'activation du relais pour la déconnection du disjoncteur principal, car le défaut est éliminé par le disjoncteur en aval du dispositif optique et il est sans risque pour l'installation. Par contre, en cas de défaut entre les parties sous tension d'une installation, il est impératif de supprimer l'arc généré en un temps très bref afin de protéger le personnel proche du défaut (temps inférieur à 3ms). Un tel appareillage ne permet donc pas de conserver de manière sure la sélectivité entre les deux disjoncteurs, c'est-à-dire la coordination des dispositifs de protection pour obtenir qu'un défaut survenant en un point quelconque du réseau soit éliminé par le disjoncteur placé immédiatement en amont du défaut.

On connaît le document US 2009/161272 décrivant un procédé selon le préambule de la revendication 1.

### EXPOSE DE L'INVENTION

La présente invention résout ces problèmes et propose un procédé et un dispositif de protection contre les défauts d'arc internes permettant de discriminer très simplement la lumière provenant d'un défaut d'arc interne entre deux conducteurs, de celle provenant des gaz ionisés éjectés par les échappements d'un disjoncteur basse tension, cette discrimination permettant de conserver la sélectivité entre les protections basse tension , ainsi que l'intégrité de l'armoire de distribution électrique comportant un tel dispositif.

A cet effet, la présente invention a pour objet un procédé de protection contre les défauts d'arc interne selon la revendication 1.

Selon une caractéristique particulière, entre l'étape de détection et l'étape d'analyse précitées, on bloque toutes les ondes lumineuses du faisceau ayant une fréquence strictement supérieure à 430nm.

Selon une caractéristique particulière, l'étape d'analyse précitée comporte une étape de mesure de l'intensité du faisceau lumineux.

La présente invention a encore pour objet un dispositif de protection contre les défauts d'arc interne dans un système de distribution électrique comportant :
- un détecteur de lumière (1) placé à l'intérieur du système de distribution précité et apte à détecter un faisceau lumineux compris entre 300 et 430nm à l'intérieur de ce système, et à générer un signal indicatif d'un arc interne à l'intérieur du système,
- des moyens de traitement couplés au détecteur précité (1) et configurés pour analyser ce faisceau lumineux à partir du signal précité, et à générer un signal indicatif d'un défaut d'arc interne si les conditions d'un tel défaut sont observées, et
- des moyens de protection électriques (3) configurés pour recevoir le signal de défaut d'arc et pour atténuer l'arc dans le système de distribution.

Ce dispositif est caractérisé en ce que ce détecteur est apte à éliminer la partie de type visible et la partie de type infra rouge de ce faisceau lumineux, et à générer un signal indicateur de la présence d'un arc interne se propageant dans le système en présence d'une partie de faisceau lumineux autre que de type visible ou IR, dite partie restante du faisceau, et en ce que les moyens de traitement précités sont configurés pour analyser cette partie de faisceau autre que de type visible ou IR, à partir du signal précité, et à générer un signal indicatif de défaut d'arc interne si les conditions d'un tel défaut sont observées.

Selon une caractéristique particulière, les moyens de traitement précités comportent un moyen de mesure de l'intensité de cette partie restante de faisceau lumineux.

Selon une autre caractéristique, ce détecteur lumineux comporte au moins un capteur optique ou bien au moins une fibre optique.

Selon une autre caractéristique, le ou chaque capteur optique comporte au moins une photo diode(s) et/ou au moins un photo transistor(s), le ou chaque photo diode ou photo transistor étant équipé d'un filtre passe bas bloquant les faisceaux de longueur d'onde supérieure à 450nm (+/-20nm).

Selon une autre réalisation, le ou chaque capteur optique comporte au moins une photo diodes et/ou au moins un photo transistors, le ou chaque photo diode ou photo transistor étant équipé d'un filtre passe bande de 400nm (+/-20nm).

Selon une caractéristique particulière, la ou chaque fibre optique est du type transportant les UV, et est associée à un filtre passe bande de 400nm (+/-20nm) ou à un filtre optique passe bas bloquant les longueurs d'onde supérieures à 450nm (+/-20nm).

On notera qu'il sera possible d'obtenir des dépôts de couches minces directement sur l'extrémité d'une fibre avec un système d'évaporation à faisceau d'électrons.

La présente invention a encore pour objet un système de distribution électrique comportant un dispositif de protection comportant les caractéristiques précédemment mentionnées prises seules ou en combinaison.

Selon une caractéristique particulière, ce système comprend un jeu de barres, un dispositif de protection comportant les caractéristiques précédemment mentionnées prises seules ou en combinaison, ainsi que des moyens de protection électrique destinés à atténuer les effets d'un éventuel défaut d'arc interne à l'intérieur du système.

Selon une caractéristique particulière, les moyens de protection précités comportent un disjoncteur dit principal alimenté par le jeu de barres précité, un relais apte à recevoir des informations de mesure concernant d'une part la lumière à l'intérieur du système et d'autre part, le courant circulant dans le jeu de barres, et un court-circuiteur relié électriquement d'une part au disjoncteur principal et d'autre part au relais, ledit relais étant apte à envoyer, lorsque la valeur seuil est atteinte pour les deux mesures précitées, deux ordres en parallèle respectivement, un ordre pour activer le court-circuiteur, et un ordre pour activer l'ouverture du disjoncteur principal.

Selon une autre caractéristique, ce système comporte en outre au moins un disjoncteur basse tension à coupure dans l'air situé en aval du dispositif de détection de lumière.

Selon une autre caractéristique, ce système est une armoire électrique basse tension.

Mais d'autres avantages et caractéristiques de l'invention apparaîtront mieux dans la description détaillée qui suit et se réfère aux dessins annexés donnés uniquement à titre d'exemple et dans lesquels :
- La figure 1 est une vue partielle, illustrant un dispositif de protection contre les arcs électriques, selon l'invention, monté dans une armoire électrique,
- La figure 2 est une représentation graphique illustrant l'intensité d'un faisceau lumineux en fonction de sa longueur d'onde, ce faisceau lumineux étant généré dans l'armoire électrique lors de la présence simultanée d'un défaut d'arc interne et d'un court-circuit coupé par un disjoncteur basse tension, et
- La figure 3 est une même représentation graphique, illustrant la partie de faisceau lumineux détectée par le détecteur de lumière selon l'invention.

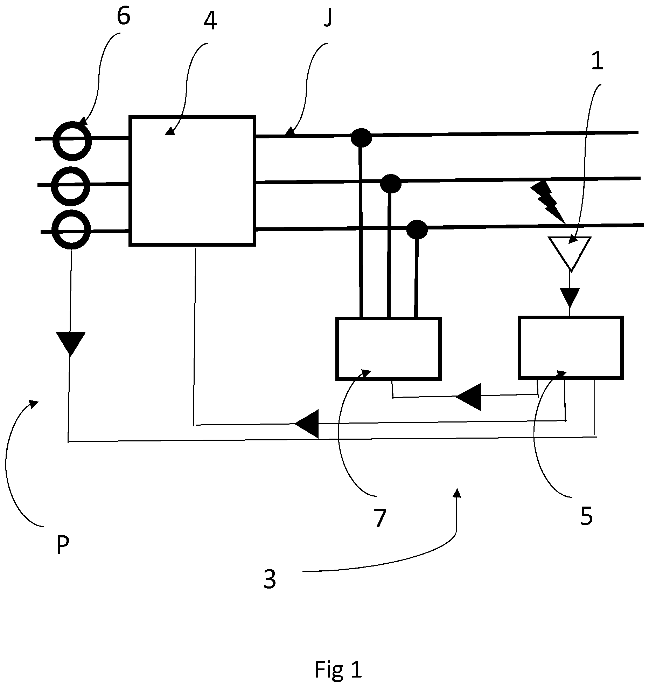

Sur la figure 1, on voit un dispositif de protection électrique P contre les défauts d'arc internes, destiné à être installé à l'intérieur d'un système de distribution électrique, ici une armoire électrique, logeant un jeu de barres J, ledit jeu de barres étant destiné à alimenter ou bien relier électriquement des organes de commande et/ou de protection tels des disjoncteurs ou des contacteurs basse tension.

Ce dispositif de protection électrique P comporte de manière connue en soi un détecteur d'arc comportant d'une part un capteur détecteur de lumière 1 associé à un capteur de mesure de courant 6 et d'autre part, des moyens de protection électrique 3 destinés à atténuer les effets d'un éventuel défaut d'arc.

Ces moyens de protection électrique 3 comportent un disjoncteur dit principal 4 alimenté par le jeu de barres précité J, un relais 5 apte à recevoir des informations concernant d'une part, la lumière émise à l'intérieur du système de distribution par l'intermédiaire du détecteur de lumière 1, et d'autre part, le courant circulant dans le jeu de barres J, par l'intermédiaire de capteurs de courant 6 placés sur les différentes barres, ainsi qu'un court-circuiteur 7. Ce court-circuiteur 7 est relié électriquement d'une part, au jeu de barres J, et d'autre part, au relais 5. Le relais est apte à envoyer, lorsque la valeur seuil est atteinte pour les deux mesures précitées concernant la lumière et le courant, deux ordres en parallèle respectivement, un ordre pour activer le court-circuiteur 7, et un ordre pour activer l'ouverture du disjoncteur principal 4.

Selon l'invention, ce détecteur de lumière 1 comporte des moyens pour éliminer les parties de type visible et les parties de type infra rouge du faisceau lumineux émis. Avantageusement, ce détecteur de lumière 1 comporte des moyens pour bloquer toutes les ondes lumineuses ayant une fréquence strictement supérieure à 430 nm.

Selon la réalisation illustrée sur la figure 1, ce détecteur de lumière 1 est un capteur optique constitué par une photo diode captant les lumières UV, visible et IR, cette photo diode étant équipée d'un filtre bloquant les longueurs d'ondes supérieures à 450nm (+/-20nm).

D'autres types de capteurs pourraient être utilisés, tels que par exemple, des photo transistors équipés de filtres bloquant les longueurs d'ondes ou bien de filtres passe bandes.

Ainsi, pour ce qui concerne les capteurs points, on pourra envisager d'équiper des photo diodes ou photo transistors standard à bas cout (captant les lumières UV, visible et IR) d'un filtre bloquant les longueurs d'onde supérieures à 450nm (+/-20nm) ou bien d'un filtre passe bande de 400nm (+/-20nm).

Ces capteurs optiques peuvent être réalisés également par des fibres optiques. Dans ce cas, il est possible d'opter pour des fibres optiques transportant les UV sans atténuation associées à des filtres passe bande de 400nm (+/-20nm) ou bien des filtres optiques passe bas bloquant les longueurs d'onde supérieures à 450nm (+/-20nm).

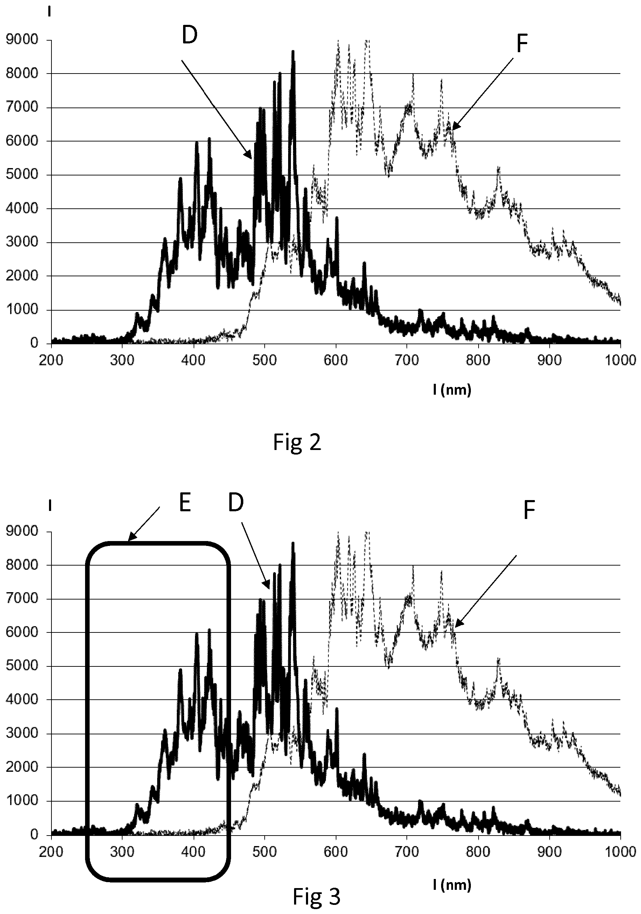

Les figures 2 et 3 illustrent le spectre du faisceau lumineux présent à l'intérieur du système de distribution en présence à la fois d'un défaut d'arc interne et d'un défaut de court-circuit, ces deux figures représentant respectivement l'intensité I du faisceau en fonction de la longueur d'onde I.

Sur les figures 2 et 3, les parties de faisceau F correspondent à un faisceau lumineux généré par les échappements d'un disjoncteur basse tension situé en aval du capteur de lumière et coupant un courant de court-circuit, tandis que les parties de faisceau D correspondent au faisceau lumineux généré par la présence d'un défaut d'arc interne à l'intérieur du système de distribution.

La figure 3 illustre par un encadré E la sélection réalisée par le capteur de lumière, lequel ne prend en compte que les ondes lumineuses de longueur d'ondes inférieures à 450nm.

Ainsi, le procédé et le dispositif de protection contre les arcs internes selon l'invention permettent de détecter la lumière générée par un arc interne accidentel naissant entre deux parties sous tension d'une installation électrique (2 phases) (ou une phase et le neutre) tout en restant inactif lorsque la lumière est générée par les gaz d'échappement d'un disjoncteur basse tension interrompant un défaut électrique extérieur à l'armoire.

Ceci est rendu possible grâce à un dispositif comportant par exemple un capteur ou fibre optique configuré pour éliminer la lumière visible et IR et générer un signal indicateur d'un évènement d'arc se propageant à l'intérieur de l'armoire, des moyens de traitement couplés au capteur et configurés pour analyser une caractéristique lumineuse à partir du signal envoyé par le capteur et à générer un signal indicateur d'un défaut d'arc interne. Par exemple, cette caractéristique lumineuse peut être l'intensité de la lumière, laquelle lorsqu'elle est supérieure à 8000 Lux, entraînerait un changement d'état du relais afin d'indiquer un défaut d'arc interne.

Enfin, le dispositif de protection selon l'invention comporte également des moyens de protection configurés pour recevoir le signal de défaut d'arc interne et atténuer son effet dans l'armoire de distribution.

En fonctionnement, le relais reçoit deux informations, l'une concernant la lumière, une autre concernant le courant. Mais à ce stade, l'éventualité d'une lumière émise par un disjoncteur est éliminée. Si la valeur seuil est atteinte pour les deux mesures concernant la lumière et le courant, le relais envoie deux ordres en parallèle, l'un pour activer le court-circuiteur pyrotechnique, l'autre pour activer l'ouverture du disjoncteur de tête. L'activation du court-circuiteur et l'ouverture du disjoncteur ne s'effectuent que s'il s'agit d'un défaut d'arc interne.

Ainsi, l'invention permet un déclenchement sélectif entre les arcs internes et ceux générés par les disjoncteurs basse tension à coupure dans l'air.

Ce procédé permet à la fois de conserver la sélectivité des protections basse tension et permet d'assurer la protection des personnes travaillant à proximité des conducteurs sous tension.

En effet, soit le dispositif détecte un défaut d'arc interne et ce défaut sera éliminé par la déconnection réalisée par le disjoncteur principal et le court-circuiteur, soit il s'agira d'un défaut de court-circuit de type « boulonné », lequel ne sera pas détecté par le détecteur d'arc interne, mais sera éliminé par le disjoncteur basse tension situé en aval du détecteur d'arc interne.

Bien entendu, l'invention n'est pas limitée aux modes de réalisation décrits et illustrés qui n'ont été donnés qu'à titre d'exemple.

Au contraire, l'invention comprend tous les équivalents techniques des moyens décrits ainsi que leurs combinaisons si celles-ci sont réalisées suivant son esprit.

## Revendications

1. Procédé de protection contre les défauts d'arc interne dans un système de distribution électrique, comprenant les étapes consistant à :
- détecter tout faisceau lumineux compris entre 300 et 430 nm à l'intérieur du système de distribution et, en cas de présence de ce faisceau, générer un signal indicatif de la présence d'un arc interne à l'intérieur du système,
- analyser les caractéristiques du faisceau lumineux précité à partir du signal précité et, si ces caractéristiques répondent aux conditions requises pour caractériser un défaut d'arc interne, envoyer un signal de défaut d'arc interne puis,
- en présence d'un défaut d'arc interne, atténuer ses effets dans le système de distribution,
- **caractérisé en ce que** le système de distribution précité loge un jeu de barres, ledit jeu de barres alimentant un disjoncteur principal et étant relié électriquement en aval à au moins un disjoncteur basse tension, et **en ce que**, entre l'étape de détection et l'étape d'analyse précités, on élimine la partie de type visible et la partie de type infra rouge de ce faisceau, ces parties étant susceptibles de provenir des gaz ionisés éjectés par les échappements d'un disjoncteur basse tension coupant un courant de court-circuit, de sorte qu'en présence d'un défaut d'arc, soit le dispositif de protection détecte un défaut d'arc interne et ce défaut sera éliminé par la déconnexion réalisée par le disjoncteur principal, soit il s'agira d'un défaut de court-circuit, lequel ne sera pas détecté par le détecteur d'arc interne du fait de l'élimination précitée de la partie visible et de la partie infra rouge de ce faisceau, mais sera éliminé par le au moins un disjoncteur basse tension situé en aval du détecteur d'arc interne.

2. Procédé de protection selon la revendication 1, **caractérisé en ce que**, entre l'étape de détection et l'étape d'analyse précitées, on bloque toutes les ondes lumineuses du faisceau ayant une fréquence strictement supérieure à 430nm.

3. Procédé de protection selon la revendication 1 ou 2, **caractérisé en ce que** l'étape d'analyse précitée comporte une étape de mesure de l'intensité du faisceau lumineux.

4. Dispositif de protection contre les défauts d'arc interne dans un système de distribution électrique comportant :
- un détecteur de lumière (1) placé à l'intérieur du système de distribution précité et apte à détecter un faisceau lumineux compris entre 300 et 430nm à l'intérieur de ce système, et à générer un signal indicatif d'un arc interne à l'intérieur du système,
- des moyens de traitement couplés au détecteur précité (1) et configurés pour analyser ce faisceau lumineux à partir du signal précité, et à générer un signal indicatif d'un défaut d'arc interne si les conditions d'un tel défaut sont observées, et
- des moyens de protection électriques (3) configurés pour recevoir le signal de défaut d'arc et pour atténuer l'arc dans le système de distribution, **caractérisé en ce que** ce détecteur (1) est apte à éliminer la partie de type visible et la partie de type infra rouge de ce faisceau lumineux, et à générer un signal indicateur de la présence d'un arc interne se propageant dans le système en présence d'une partie de faisceau lumineux autre que de type visible ou IR, dite partie restante du faisceau, et **en ce que** les moyens de traitement précités sont configurés pour analyser cette partie de faisceau autre que de type visible ou IR, à partir du signal précité, et à générer un signal indicatif de défaut d'arc interne si les conditions d'un tel défaut sont observées.

5. Dispositif de protection selon la revendication 4, **caractérisé en ce que** les moyens de traitement précités comportent un moyen de mèsure de l'intensité de cette partie restante de faisceau lumineux.

6. Dispositif de protection selon la revendication 4 ou 5, **caractérisé en ce que** ce détecteur lumineux (1) comporte au moins un capteur optique ou bien au moins une fibre optique.

7. Dispositif de protection selon la revendication 6, **caractérisé en ce que** le ou chaque capteur optique comporte au moins une photo diode(s) et/ou au moins un photo transistor(s), le ou chaque photo diode ou photo transistor étant équipé d'un filtre passe bas bloquant les faisceaux de longueur d'onde supérieure à 450nm (+/-20nm).

8. Dispositif de protection selon la revendication 6, **caractérisé en ce que** le ou chaque capteur optique comporte au moins une photo diodes et/ou au moins un photo transistors, le ou chaque photo diode ou photo transistor étant équipé d'un filtre passe bande de 400nm (+/-20nm).

9. Dispositif de protection selon la revendication 6, **caractérisé en ce que** la ou chaque fibre optique est du type transportant les UV, et est associée à un filtre passe bande de 400nm (+/-20nm) ou à un filtre optique passe bas bloquant les longueurs d'onde supérieures à 450nm (+/-20nm).

10. Système de distribution électrique, **caractérisé en ce qu'**il comporte un dispositif de protection selon l'une quelconque des revendications 4 à 9.

11. Système de distribution électrique comprenant un jeu de barres J, un dispositif de protection P selon l'une quelconque des revendications 4 à 9, ainsi que des moyens de protection électrique (3) destinés à atténuer les effets d'un éventuel défaut d'arc interne à l'intérieur du système.

12. Système de distribution électrique selon la revendication 11, **caractérisé en ce que** les moyens de protection précités (3) comportent un disjoncteur dit principal (4) alimenté par le jeu de barres précité J, un relais (5) apte à recevoir des informations de mesure concernant d'une part la lumière à l'intérieur du système et d'autre part, le courant circulant dans le jeu de barres J, et un court-circuiteur (7) relié électriquement d'une part au disjoncteur principal (4) et d'autre part au relais (5), ledit relais étant apte à envoyer, lorsque la valeur seuil est atteinte pour les deux mesures précitées, deux ordres en parallèle respectivement, un ordre pour activer le court-circuiteur (7), et un ordre pour activer l'ouverture du disjoncteur principal (4).

13. Système de distribution selon l'une quelconque des revendications 10 à 12, **caractérisé en ce qu'**il comporte en outre au moins un disjoncteur basse tension à coupure dans l'air situé en aval du dispositif de détection de lumière (1).

14. Système de distribution selon la revendication 13, **caractérisé en ce que** c'est une armoire électrique basse tension.

## Patentansprüche

1. Verfahren zum Schutz vor Störlichtbogenfehlern in einem elektrischen Verteilersystem, das die Schritte enthält, die darin bestehen:
- jedes Lichtbündel zwischen 300 und 430 nm innerhalb des Verteilersystems zu erfassen, und im Fall des Vorhandenseins dieses Bündels ein das Vorhandensein eines Störlichtbogens innerhalb des Systems anzeigendes Signal zu erzeugen,
- die Merkmale des erwähnten Lichtbündels ausgehend vom erwähnten Signal zu analysieren, und wenn diese Merkmale die erforderlichen Bedingungen zur Charakterisierung eines Störlichtbogenfehlers erfüllen, ein Störlichtbogenfehlersignal zu senden, dann,
- in Gegenwart eines Störlichtbogenfehlers, seine Wirkungen im Verteilersystem zu dämpfen,
- **dadurch gekennzeichnet, dass** eine Sammelschiene im erwähnten Verteilersystem untergebracht ist, wobei die Sammelschiene einen Hauptschalter speist und elektrisch stromabwärts mit mindestens einem Niederspannungsschalter verbunden ist, und dass zwischen den erwähnten Erfassungsschritten und Analyseschritten der sichtbare Bereich und der Infrarotbereich aus diesem Bündel entfernt werden, wobei diese Bereiche von den ionisierten Gasen stammen können, die von den Abgasen eines Niederspannungsschalters ausgestoßen werden, der einen Kurzschlussstrom unterbricht, so dass in Gegenwart eines Lichtbogenfehlers entweder die Schutzvorrichtung einen Störlichtbogenfehler erfasst und dieser Fehler durch die vom Hauptschalter durchgeführte Trennung entfernt wird, oder es sich um einen Kurzschlussfehler handelt, der aufgrund der erwähnten Entfernung des sichtbaren Bereichs und des Infrarotbereichs aus diesem Bündel nicht vom Störlichtbogendetektor erfasst wird, sondern von dem mindestens einen Niederspannungsschalter entfernt wird, der sich stromabwärts hinter dem Störlichtbogendetektor befindet.

2. Schutzverfahren nach Anspruch 1, **dadurch gekennzeichnet, dass** zwischen den erwähnten Erfassungsschritten und Analyseschritten alle Lichtwellen des Bündels blockiert werden, die eine Frequenz strikt höher als 430nm haben.

3. Schutzverfahren nach Anspruch 1 oder 2, **dadurch gekennzeichnet, dass** der erwähnte Analyseschritt einen Schritt der Messung der Stärke des Lichtbündels aufweist.

4. Vorrichtung zum Schutz vor den Störlichtbogenfehlern in einem elektrischen Verteilersystem, die aufweist·:
- einen Lichtdetektor (1), der innerhalb des erwähnten Verteilersystems angeordnet und fähig ist, ein Lichtbündel zwischen 300 und 430nm innerhalb dieses Systems zu erfassen und ein Signal zu erzeugen, das einen Störlichtbogen innerhalb dieses Systems anzeigt,
- Verarbeitungseinrichtungen, die mit dem erwähnten Detektor (1) gekoppelt und konfiguriert sind, dieses Lichtbündel ausgehend von dem erwähnten Signal zu analysieren und ein Signal zu erzeugen, das einen Störlichtbogenfehler anzeigt, wenn die Bedingungen eines solchen Fehlers festgestellt werden, und
- elektrische Schutzeinrichtungen (3), die konfiguriert sind, das Lichtbogenfehlersignal zu empfangen und den Lichtbogen im Verteilersystem zu dämpfen,
**dadurch gekennzeichnet, dass** dieser Detektor (1) fähig ist, den sichtbaren Bereich und den Infrarotbereich aus diesem Lichtbündel zu entfernen und ein Signal zu erzeugen, das das Vorhandensein eines Störlichtbogens anzeigt, der sich im System in Gegenwart eines Lichtbündelbereichs anders als der sichtbare oder IR-Bereich, verbleibender Bereich des Bündels genannt, ausbreitet, und dass die erwähnten Verarbeitungseinrichtungen konfiguriert sind, diesen Bündelbereich anders als der sichtbare oder IR-Bereich ausgehend vom erwähnten Signal zu analysieren und ein Signal zu erzeugen, das einen Störlichtbogenfehler anzeigt, wenn die Bedingungen eines solchen Fehlers festgestellt werden.

5. Schutzvorrichtung nach Anspruch 4, **dadurch gekennzeichnet, dass** die erwähnten Verarbeitungseinrichtungen eine Messeinrichtung der Stärke dieses verbleibenden Lichtbündelbereichs aufweisen.

6. Schutzvorrichtung nach Anspruch 4 oder 5, **dadurch gekennzeichnet, dass** dieser Lichtdetektor (1) mindestens einen optischen Sensor oder auch mindestens eine Lichtleitfaser aufweist.

7. Schutzvorrichtung nach Anspruch 6, **dadurch gekennzeichnet, dass** der oder jeder optische Sensor mindestens eine Photodiode und/oder mindestens einen Phototransistor aufweist, wobei die oder jede Photodiode und/oder Phototransistor mit einem Tiefpassfilter ausgestattet ist, der die Bündel einer Wellenlänge von mehr als 450nm (+/-20nm) blockiert.

8. Schutzvorrichtung nach Anspruch 6, **dadurch gekennzeichnet, dass** der oder jeder optische Sensor mindestens eine Photodiode und/oder mindestens einen Phototransistor aufweist, wobei die oder jede Photodiode und/oder Phototransistor mit einem Tiefpassfilter von 400nm (+/-20nm) ausgestattet ist.

9. Schutzvorrichtung nach Anspruch 6, **dadurch gekennzeichnet, dass** die oder jede Lichtleitfaser vom die UV-Strahlen transportierenden Typ und einem Tiefpassfilter von 400nm (+/-20nm) oder einem optischen Tiefpassfilter zugeordnet ist, der die Wellenlängen höher als 450nm (+/-20nm) blockiert.

10. Elektrisches Verteilersystem, **dadurch gekennzeichnet, dass** es eine Schutzvorrichtung nach einem der Ansprüche 4 bis 9 aufweist.

11. Elektrisches Verteilersystem, das eine Sammelschiene J, eine Schutzvorrichtung P nach einem der Ansprüche 4 bis 9, sowie elektrische Schutzeinrichtungen (3) enthält, die dazu bestimmt sind, die Wirkungen eines möglichen Störlichtbogenfehlers innerhalb des Systems zu dämpfen.

12. Elektrisches Verteilersystem nach Anspruch 11, **dadurch gekennzeichnet, dass** die erwähnten Schutzeinrichtungen (3) einen so genannten Hauptschalter (4), der von der erwähnten Sammelschiene J gespeist wird, ein Relais (5), das Messinformationen betreffend einerseits das Licht innerhalb des Systems und andererseits den in der Sammelschiene J fließenden Strom empfangen kann, und einen Kurzschließer (7) aufweisen, der elektrisch einerseits mit dem Hauptschalter (4) und andererseits mit dem Relais (5) verbunden ist, wobei das Relais fähig ist, wenn der Schwellwert für die zwei erwähnten Messungen erreicht ist, zwei Befehle parallel zu senden, einen Befehl, um den Kurzschließer (7) zu aktivieren, und einen Befehl, um die Öffnung des Hauptschalters (4) zu aktivieren.

13. Verteilersystem nach einem der Ansprüche 10 bis 12, **dadurch gekennzeichnet, dass** es außerdem mindestens einen Niederspannungsschalter mit Luftunterbrechung aufweist, der sich stromabwärts hinter der Lichterfassungsvorrichtung (1} befindet.

14. Verteilersystem nach Anspruch 13, **dadurch gekennzeichnet, dass** es ein Niederspannungs-Schaltschrank ist.

## Claims

1. Method for protection from internal arc faults in an electrical distribution system, comprising the steps consisting in:
- detecting any light beam comprised between 300 and 430 nm within the distribution system and, in the event of the presence of this beam, generating a signal indicating the presence of an internal arc inside the system;
- analysing the characteristics of the aforementioned light beam on the basis of the aforementioned signal and, if these characteristics meet the required conditions for characterizing an internal arc fault, sending an internal arc fault signal, then;
- in the presence of an internal arc fault, attenuating its effects in the distribution system,
- **characterized in that** the aforementioned distribution system houses a set of busbars, said set of busbars supplying power to a main circuit breaker and being electrically connected downstream to at least one low-voltage circuit breaker, and **in that**, between the aforementioned detection step and the aforementioned analysis step, the visible portion and the infrared portion of this beam are removed, these portions being liable to arise from ionized gases ejected by the exhausts of a low-voltage circuit breaker disconnecting a short-circuit current, such that, in the presence of an arc fault, either the protection device detects an internal arc fault and this fault will be removed through the disconnection performed by the main circuit breaker, or it will be a short-circuit fault, which will not be detected by the internal arc detector due to the aforementioned removal of the visible portion and the infrared portion of this beam, but will be eliminated by the at least one low-voltage circuit breaker located downstream of the internal arc detector.

2. Protection method according to Claim 1, **characterized in that**, between the aforementioned detection step and the aforementioned analysis step, all light waves of the beam having a frequency that is strictly higher than 430 nm are blocked.

3. Protection method according to Claim 1 or 2, **characterized in that** the aforementioned analysis step includes a step of measuring the intensity of the light beam.

4. Device for protection from internal arc faults in an electrical distribution system, including:
- a light detector (1) placed inside the aforementioned distribution system and capable of detecting a light beam comprised between 300 and 430 nm within this system, and of generating a signal indicative of an internal arc inside the system;
- processing means coupled to the aforementioned detector (1) and configured to analyse this light beam on the basis of the aforementioned signal, and to generate a signal indicative of an internal arc fault if the conditions of such a fault are met; and
- electrical protection means (3) configured to receive the arc fault signal and to attenuate the arc in the distribution system, **characterized in that** this detector (1) is capable of removing the visible portion and the infrared portion of this light beam, and of generating a signal indicative of the presence of an internal arc propagating through the system in the presence of a portion of the light beam other than the visible or IR portion, referred to as the remaining portion of the beam, and **in that** the aforementioned processing means are configured to analyse this portion of the beam other than the visible or IR portion, on the basis of the aforementioned signal, and to generate a signal indicative of an internal arc fault if the conditions of such a fault are met.

5. Protection device according to Claim 4, **characterized in that** the aforementioned processing means include a means for measuring the intensity of this remaining portion of the light beam.

6. Protection device according to Claim 4 or 5, **characterized in that** this light detector (1) includes at least one optical sensor or else at least one optical fibre.

7. Protection device according to Claim 6, **characterized in that** the or each optical sensor includes at least one photodiode and/or at least one phototransistor, the or each photodiode or phototransistor being provided with a low-pass filter blocking those beams having a wavelength that is higher than 450 nm (+/-20 nm).

8. Protection device according to Claim 6, **characterized in that** the or each optical sensor includes at least one photodiode and/or at least one phototransistor, the or each photodiode or phototransistor being provided with a 400 nm (+/-20 nm) bandpass filter.

9. Protection device according to Claim 6, **characterized in that** the or each optical fibre is a UV-transmitting optical fibre, and is associated with a 400 nm (+/-20 nm) bandpass filter or with a low-pass optical filter blocking wavelengths that are higher than 450 nm (+/-20 nm).

10. Electrical distribution system, **characterized in that** it includes a protection device according to any one of Claims 4 to 9.

11. Electrical distribution system comprising a set of busbars J, a protection device P according to any one of Claims 4 to 9, and electrical protection means (3) that are intended to attenuate the effects of a potential internal arc fault inside the system.

12. Electrical distribution system according to Claim 11, **characterized in that** the aforementioned protection means (3) include a circuit breaker, referred to as the main circuit breaker (4), supplied with power via the aforementioned set of busbars J, a relay (5) capable of receiving measurement information relating both to the light inside the system and to the current flowing through the set of busbars J, and a short-circuiter (7) that is electrically linked both to the main circuit breaker (4) and to the relay (5), said relay being capable of sending, when the threshold value is reached for the two aforementioned measurements, two orders in parallel: an order to activate the short-circuiter (7), and an order to activate the opening of the main circuit breaker (4), respectively.

13. Distribution system according to any one of Claims 10 to 12, **characterized in that** it further includes at least one low-voltage air circuit breaker located downstream of the light detection device (1).

14. Distribution system according to Claim 13, **characterized in that** it is a low-voltage electrical cabinet.
